# EUROPÄISCHE PATENTSCHRIFT

(11) **EP 1 393 375 B1**
(45) Veröffentlichungstag und Bekanntmachung des Hinweises auf die Patenterteilung: **17.03.2010**
(21) Anmeldenummer: 02727149.3
(22) Anmeldetag: 30.05.2002
(51) Int. Cl.: H01L 25/11, H01L 23/051

(54) **KONTAKTANORDNUNG**
CONTACT SYSTEM
SYSTEME DE CONTACT

(30) Priorität: 01.06.2001 EP 01113344
(43) Veröffentlichungstag der Anmeldung: 03.03.2004
(73) Patentinhaber: ABB Schweiz AG, 5400 Baden (CH)
(72) Erfinder: KAUFMANN, Stefan, CH-5000 Aarau (CH)
(74) Vertreter: ABB Patent Attorneys
(86) Internationale Anmeldenummer: PCT/CH2002/000284
(87) Internationale Veröffentlichungsnummer: WO 2002/097885

(56) Entgegenhaltungen:
- EP-A- 0 772 235
- DE-A- 19 603 224
- US-A- 4 710 795
- US-A- 5 579 217

## Beschreibung

### Technisches Gebiet

Die Erfindung bezieht sich auf das Gebiet der Leistungselektronik. Sie geht aus von einem Leistungshalbleitermodul gemäss dem Oberbegriff des Patentanspruchs 1.

### Stand der Technik

Bei sogenannten 'Hockeypuck'-Halbleitermodulen handelt es sich um Halbleitermodule, welche beispielsweise in einem Stapel aus mehreren Modulen eingesetzt werden, wobei die Module in der Regel die Form eines Hockey Pucks haben, d.h. im wesentlichen zylinderförmig mit zwei parallel gegenüberliegenden Grundflächen. Die Grundflächen sind elektrisch leitfähig ausgebildet und mit den Leistungs- oder Hauptelektroden (Emitter, Kollektor) der Halbleiter verbunden, während die Seitenwand zwischen den Grundflächen elektrisch isolierend ausgebildet ist. In einem Stapel mit mehreren seriengeschalteten Modulen ist jeweils zwischen je zwei Modulen, im Hauptstrompfad, ein Kühlkörper angeordnet. Zur Steuerung und Überwachung der Leistungshalbleiterelemente sind jeweils ein Steueranschluss (Gate) und ein Hilfsanschluss (auxiliary Emitter) aus dem Modulgehäuse geführt. Bei herkömmlichen 'Hockeypuck'-Modulen bestehen diese Anschlüsse aus herausstehenden Stiften, wobei der Hilfsanschluss an die eine Grundfläche (Emitter) angelötet sind.

Diese Stifte können bei Einwirkungen von Gewalt leicht abbrechen. Die Lötstelle kann ebenfalls beschädigt werden. Zusätzlich ist die Induktivität zwischen den stiftartigen Kontakten relativ hoch.

Aus EP 0 772 235 ist ein Halbleitermodul bekannt, welches eine Halbleiterschaltung bestehend aus IGBTs in einem elektrisch isolierenden Gehäuse umfasst. Mit den Hauptelektroden der IGBTs sind zwei Leistungsanschlüsse verbunden, welche durch eine Seitenwand aus dem Modulgehäuse geführt sind. Die Leistungsanschlüsse sind im wesentlichen als flache Platten ausgebildet, welche durch eine Isolierschicht getrennt parallel zueinander angeordnet sind. Ein Steueranschluss der IGBTs ist an einer anderen Stelle durch die Seitenwand aus dem Modul geführt.

### Kurze Darstellung der Erfindung

Die Aufgabe der Erfindung besteht darin, eine betreffend der Stabilität der Kontakte und der Induktivität zwischen den Kontakten verbessertes Leistungshalbleitermodul der eingangs genannten Art zu schaffen.

Diese Aufgabe wird mit einem Leistungshalbleitermodul mit den Merkmalen des Patentanspruchs 1 gelöst.

Der Kern der Erfindung besteht darin, dass die beiden aus dem Modulgehäuse herausgeführten Anschlüsse der Leistungshalbleiterschaltung auf gegenüberliegenden Flächen einer aus dem Modulgehäuse herausgeführten Leiterplatte (printed circuit board, PCB) angeordnet sind, und dass die Leiterplatte mit Befestigungsmittel an der Deckelplatte kraftschlüssig befestigt ist, so dass der zwischen Leiterplatte und Deckelplatte angeordnete Deckelplatten-Anschluss mit der Deckelplatte elektrisch leitfähig verbunden ist, wobei das Befestigungsmittel vorteilhafterweise im Bereich der Verbindungsstelle angeordnet ist.

Dadurch weisen die Anschlüsse eine erhöhte Stabilität bei geringerer Induktivität auf. Darüberhinaus ist eine optimale elektrische Verbindung zwischen der Deckelplatte und dem Deckelplatten-Anschluss ist gewährleistet.

Vorteilhafterweise weisen die Deckelplatte und/ oder der Deckelplatten-Anschluss im Bereich der Verbindungsstelle eine Rändelung auf. Dadurch wird die elektrische Verbindung zusätzlich verbessert. Ein sicherer elektrischer Kontakt über eine längere Zeit kann so selbst bei variablen Bedingungen (Temperatur, Feuchtigkeit) erreicht werden.

In einer weiteren bevorzugen Ausführungsform des erfindungsgemässen Leistungshalbleitermoduls weisen die Deckel- und die Leiterplatte je mindestens zwei Vorsprünge auf. Jeweils ein Vorsprung der Deckel- und der Leiterplatte sind übereinander angeordnet und die Befestigungsmittel sind im Bereich der Vorsprünge angeordnet. Zudem weist die Leiterplatte zwischen den beiden Vorsprüngen mindestens einen weiteren Vorsprung auf.

Die beiden Vorsprünge der Deckelplatte sorgen dafür, dass der weitere Vorsprung der Leiterplatte gegenüber Schlägen geschützt ist. Dieser Vorsprung ist vorteilhafterweise im wesentlichen reckteckig ausgebildet, damit er mit einem herkömmlichen Stecker kontaktiert werden kann.

### Kurze Beschreibung der Zeichnungen

Eine detaillierte Beschreibung der Erfindung erfolgt nachstehend anhand von Ausführungsbeispielen, die in den Zeichnungen dargestellt sind. Dabei zeigen
- Fig. 1: schematisch dargestellt, ein efindungsgemässes Leistungshalbleitermodul, mit einer Deckelplatte und einer Leiterplatte,
- Fig. 2: einen Teil eines Leistungshalbleitermoduls nach Fig. 1, mit der Deckelplatte und einer ersten Ausführungsform der Leiterplatte,
- Fig. 3: eine Ansicht auf einen entlang III-III geführten Schnitt durch das Leistungshalbleitermodul nach Fig. 2,
- Fig. 4: eine Ansicht auf einen entlang IV-IV geführten Schnitt durch das Leistungshalbleitermodul nach Fig. 2,
- Fig. 5: eine Ansicht von oben auf eine zweite Ausführungsform der Leiterplatte nach Fig. 2, und
- Fig. 6: eine Ansicht von unten auf die Leiterplatte nach Fig. 5.

### Weg zur Ausführung der Erfindung

In allen Figuren beziehen sich gleiche Bezugszeichen auf gleichwirkende Teile.

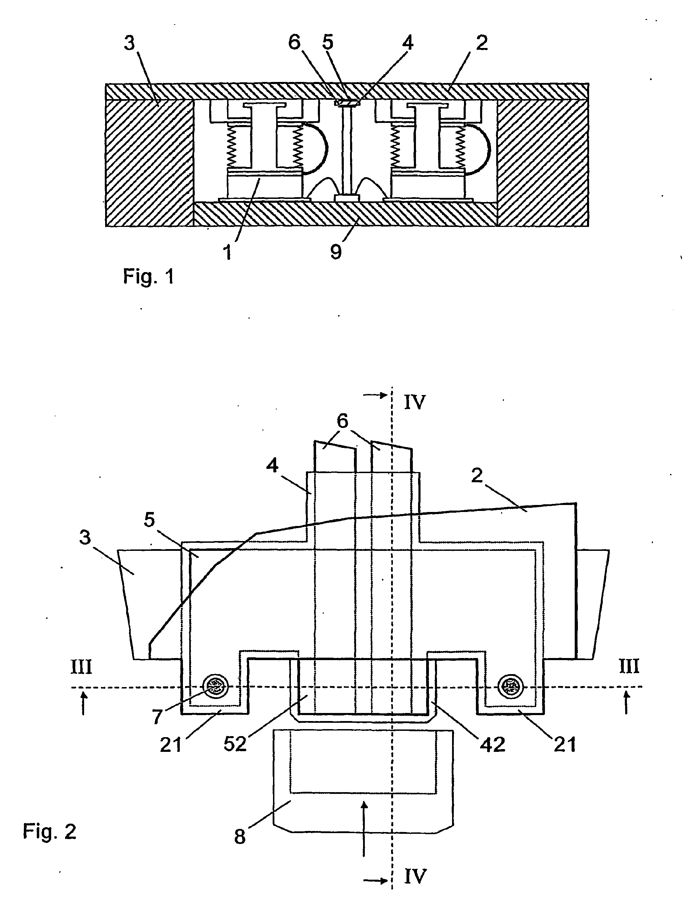

Das Leistungshalbleitermodul in Fig. 1 umfasst eine Leistungshalbleiterschaltung 1 bestehtend aus zwei Leistungshalbleitern. Die Funktion und der Aufbau der Leistungshalbleiterschaltung ist beliebig und für die Erfindung nicht relevant. So können beispielsweise mehrere Halbleiterelemente in vorfabrizierbaren Submodulen zusammengefasst sein.

Die Leistungshalbleiterschaltung 1 ist in einem Modulgehäuse untergebracht, welches im wesentlichen aus einer elektrisch leitenden Deckelplatte 2, einer elektrisch leitenden Grundplatte 9 sowie dazwischen angeordneten elektrisch isolierenden Gehäusewänden 3 besteht.

Leistungs- oder Hauptanschlüsse der Leistungshalbleiterschaltung 1 sind wie bei herkömmlichen 'Hockeypuck'-Modulen mit den leitfähigen Deckel- und Grundplatten elektrisch leitfähig verbunden.

Steuersignale für die Leistungshalbleiter, beispielsweise Gate-Steuersignale für Insulated Gate Bipolar Transistor (IGBT), werden über eine Sammelschiene und einen Steuer-Anschlussleiter 6 aus dem Gehäuse geführt.

Der Steuer-Anschlussleiter 6 ist erfindungsgemäss auf der einen Seite einer beidseitig metallisierten Leiterplatte 4 angeordnet. Auf der anderen Seite der Leiterplatte befindet sich der Deckelplatten-Anschlussleiter 5, welcher mit der Deckelplatte 2 elektrisch leitend verbunden ist.

Fig. 2 zeigt einen Teil des erfindungsgemässen Leistungshalbleitermoduls von oben betrachtet.

Zwischen der Gehäusewand 3 und der Deckelplatte 2 ist die beidseitig metallisierte Leiterplatte, 4 angeordnet. Auf der oberen, der Deckelplatte zugewandten Seite befindet sich der Deckel-Anschlussleiter 5. Auf der unteren, der Gehäusewand zugewandten Seite befinden sich zwei Steuer-Anschlussleiter 6.

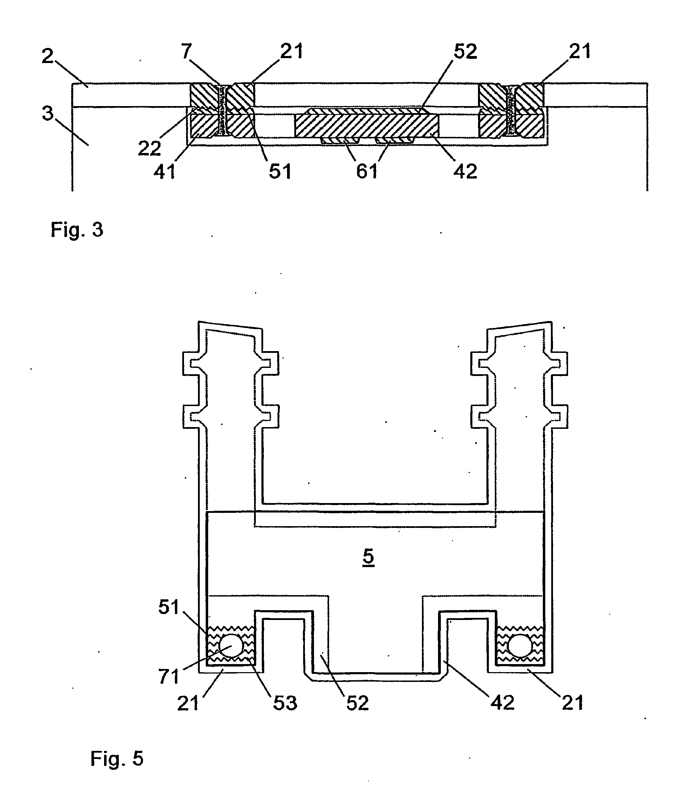

Die Deckelplatte 2 weist zwei Vorsprünge 21 auf, welche über den Modulgehäuserand hervorstehen. Wie aus Fig. 3 ersichtlich ist, weist die Leiterplatte zwei entsprechende Vorsprünge 41 auf, welche unterhalb der Vorsprünge 21 der Deckelplatte angeordnet sind. Die Vorsprünge 21 und 41 sind mit einem Befestigungsmittel 7, beispielsweise einer Niete oder einer Schraube, verbunden. Dadurch wird zwischen dem auf der Oberseite der Leiterplatte angeordneten Deckelplatten-Anschlussleiter 51 und der Deckelplatte 21 eine elektrisch leitende Verbindung erstellt. In die Unterseite des Vorsprungs 21 der Deckelplatte ist eine Rändelung 22 (aufgerauhte Oberfläche) eingelassen. Indem die bis zu einigen 100 µm langen Spitzen der Rändelung in die Metallisierung der Leiterplatte gedrückt werden, ergibt sich eine verbesserte elektrische Verbindung.

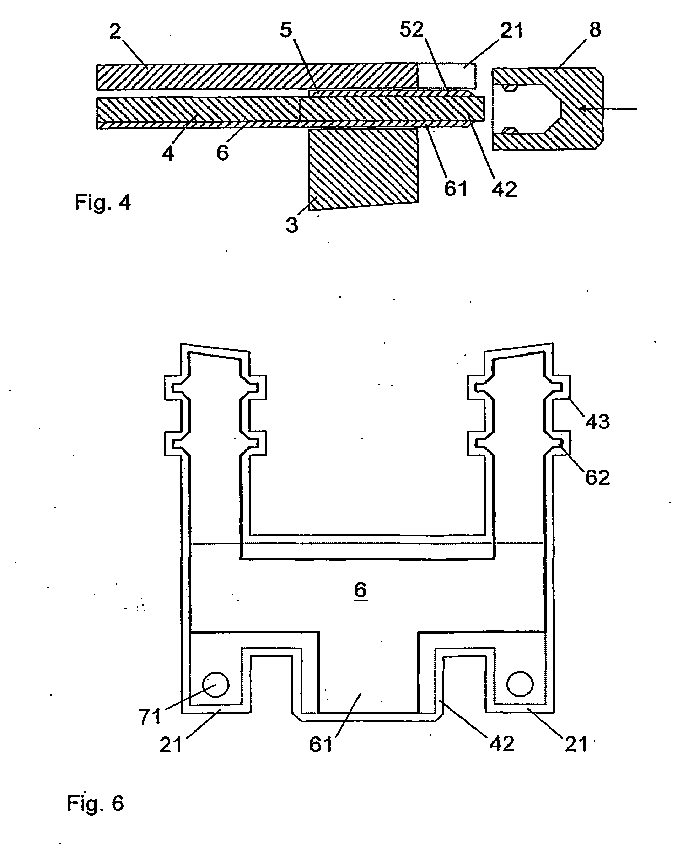

Zwischen den beiden Vorsprüngen 41 weist die Leiterplatte einen weiteren Vorsprung 42 auf. Dieser Vorsprung 42 dient der Aufnahme eines Steckers 8, wie aus Fig. 4 ersichtlich ist. Der Stecker 8 wird in Pfeilrichtung auf den Vorsprung 42 aufgeschoben. Im Stecker angeordnete Kontaktelemente werden auf die beidseits der Leiterplatte 4 angeordneten Anschlüsse 52 und 61 geschoben. Als Stecker können herkömmliche Leiterplatten-Stecker verwendet werden.

Der Vorsprung 42 ist durch die Deckeiplatten-Vorsprünge 21 gegen Schläge von oben und von der Seite geschützt.

Fig. 5 und Fig. 6 zeigen eine andere Ausführungsform der Leiterplatte mit nur einem Steuer-Anschluss 61. Zudem ist im Bereich der Aussparung 71 für die Befestigungsmittel eine Rändelung 53 in den Deckelplatten-Anschlussleiter 51 eingelassen. Durch die aufgerauhte Oberfläche ergibt sich eine verbesserte elektrische Verbindung zur Deckelplatte.

Die Leiterplatte umfasst im Innern des Modulgehäuses weitere Vorsprünge 43, welche der Kontaktierung der Steuer-Sammelschiene dienen. Vertikale Kontaktelemente (nicht gezeigt) verbinden den Steuer-Anschlussleiter 62 mit der Sammelschiene. Neben den in den Vorsprüngen 21 eingelassenen Aussparungen 71 können Aussparungen für weitere Befestigungsmittel vorgesehen werden.

Neben den gezeigten Ausführungsformen ist es denkbar, mehrere nebeneinander angeordnete Vorsprünge für mehrere Stecker zu verwenden. Dabei kann jeweils zwischen den einzelnen Stecker ein Deckelplatten-Vorsprung zum Schutz des jeweiligen Vorsprungs vorgesehen sein.

Zudem ist es denkbar, mehr als ein oder zwei Steuer-Anschlüsse pro Leiterplattenvorsprung vorzusehen.

Insbesondere sind auch Ausführungsbeispiele denkbar, mit drei- oder mehrlagigen Leiterplatten, bei der jede Leiterlage mindestens einen Anschluss umfasst.

### Bezugszeichenliste

- 1: Leistungshalbleiterschaltung
- 2: Leitfähige Deckelplatte, Emitterplatte
- 3: Isolierendes Gehäuse
- 4: Isolierende Leiterplatte
- 5, 51: Deckelplatten-Anschlussleiter
- 6, 62: Steuer-Anschlussleiter
- 7: Befestigungsmittel
- 8: Anschluss-Stecker
- 9: Leitfähige Grundplatte
- 21,41,42,43: Vorsprung
- 22, 53: Rändelung
- 52: Deckelplatten-Anschluss
- 61: Steuer-Anschluss
- 71: Aussparung für Befestigungsmittel

## Patentansprüche

1. Leistungshalbleitermodul, umfassend
- ein Modulgehäuse mit einer leitfähigen Deckelplatte (2) und einer im wesentlichen parallel zu der Deckelplatte angeordneten, leitfähigen Grundplatte (9), sowie einer zwischen der Deckel- und der Grundplatte angeordneten, isolierenden Gehäusewand (3),
- eine in dem Modulgehäuse untergebrachte Leistungshalbleiterschaltung (1), welche mindestens zwei Leistungsanschlüsse aufweist, von denen der eine mit der Deckel und der andere mit der Grundplatte elektrisch leitfähig verbunden ist, sowie
- mindestens zwei aus dem Modulgehäuse herausgeführte Anschlüsse (5, 52; 6, 61) der Leistungshalbleiterschaltung, wobei ein erster der mindestens zwei Anschlüsse (5, 52) zum Kontaktieren der Deckelplatte (2) vorgesehen ist,
**dadurch gekennzeichnet, dass**
- eine im wesentlichen flach ausgebildete Leiterplatte (4) aus dem Modulgehäuse herausgeführt ist, wobei die Leiterplatte (4) mindestens zweilagig ausgebildet ist, die beiden Anschlüsse als Leiter (5, 6) der Leiterplatte (4) ausgebildet sind, und die Leiter (5,6) im wesentlichen parallel zu den Grundflächen der Leiterplatte (4) angeordnet sind, und dass
- die Leiterplatte (4) mit Befestigungsmittel (7) an der Deckelplatte (2) kraftschlüssig befestigt ist, so dass der auf der Seite zur Deckelplatte hin angeordnete Deckelplatten-Anschlussleiter (5) mit der Deckelplatte elektrisch leitfähig verbunden ist.

2. Leistungshalbleitermodul nach Anspruch 1, **dadurch gekennzeichnet, dass**
- die Befestigungsmittel (7) im Bereich der Verbindungsstelle angeordnet sind.

3. Leistungshalbleitermodul nach einem der Ansprüche 1 oder 2, **dadurch gekennzeichnet, dass**
- die Deckelplatte (2) und/ oder der Deckelplatten-Anschlussleiter (5, 51) im Bereich der Verbindungsstelle eine kontaktoptimierende Rändelung (22, 53) aufweist.

4. Leistungshalbleitermodul nach einem der Ansprüche 1 bis 3, **dadurch gekennzeichnet, dass**
- die Deckelplatte (2) und die Leiterplatte (4) je mindestens zwei Vorsprünge (21) aufweisen, dass
- jeweils ein Vorsprung der Deckelplatte (21) und der Leiterplatte (41) übereinander angeordnet sind, dass
- die Befestigungsmittel (7) im Bereich der Vorsprünge (21, 41) angeordnet sind, dass
- die Leiterplatte (4) zwischen den beiden Vorsprüngen (41) mindestens einen weiteren Vorsprung (42) aufweist, und dass
- auf diesem weiteren Vorsprung (42) die Anschlüsse (52, 61) angeordnet sind.

## Claims

1. Power semiconductor module comprising
- a module housing having a conductive cover plate (2) and a conductive baseplate (9), arranged essentially parallel to the cover plate, and also an insulating housing wall (3) arranged between the cover plate and the baseplate,
- a power semiconductor circuit (1) accommodated in the module housing and having at least two power terminals, of which one is electrically conductively connected to the cover plate and the other is electrically conductively connected to the baseplate, and
- at least two terminals (5, 52; 6, 61) of the power semiconductor circuit which are led out of the module housing, a first of the at least two terminals (5, 52) being provided for the contact connection of the cover plate (2),
**characterized in that**
- a printed circuit board (4) formed in essentially planar fashion is led out of the module housing, the printed circuit board (4) being formed in at least two layers, the two terminals being formed as conductors (5, 6) of the printed circuit board (4) and the conductors (5, 6) being arranged essentially parallel to the base areas of the printed circuit board (4), and **in that**
- the printed circuit board (4) is fixed to the cover plate (2) by fixing means (7) in a force-locking manner, so that the cover plate terminal conductor (5) arranged on the side toward the cover plate is electrically conductively connected to the cover plate.

2. Power semiconductor module according to Claim 1, **characterized in that**
- the fixing means (7) are arranged in the region of the connection location.

3. Power semiconductor module according to either of Claims 1 and 2, **characterized in that**
- the cover plate (2) and/or the cover plate terminal conductor (5, 51) has a contact-optimizing knurl (22, 53) in the region of the connection location.

4. Power semiconductor module according to one of Claims 1 to 3, **characterized in that**
- the cover plate (2) and the printed circuit board (4) each have at least two projections (21), **in that**
- a respective projection of the cover plate (21) and of the printed circuit board (41) are arranged one above the other, **in that**
- the fixing means (7) are arranged in the region of the projections (21, 41), **in that**
- the printed circuit board (4) has at least one further projection (42) between the two projections (41), and **in that**
- the terminals (52, 61) are arranged on said further projection (42).

## Revendications

1. Module semi-conducteur de puissance, qui comprend :
- un boîtier de module doté d'une plaque conductrice de couvercle (2) et d'une plaque conductrice de base (9) disposée essentiellement en parallèle à la plaque de couvercle, ainsi qu'une paroi isolante de boîtier (3) disposée entre la plaque de couvercle et la plaque de base,
- un circuit semi-conducteur de puissance (1) installé dans le module de boîtier et doté d'au moins deux bornes raccordement de puissance reliées de manière conductrice l'une à la plaque de couvercle et l'autre à la plaque de base, ainsi que
- au moins deux bornes de raccordement (5, 52; 6, 61) du circuit semi-conducteur de puissance, prolongées hors du boîtier du module, une première des deux ou plusieurs bornes de raccordement (5, 52) étant prévue pour assurer le contact avec la plaque de couvercle (2),
**caractérisé en ce que**
- une plaque conductrice (4) de configuration essentiellement aplatie est prolongée hors du module de boîtier, la plaque conductrice (4) étant configurée en au moins deux couches, les deux bornes de raccordement étant configurées comme conducteurs (5, 6) de la plaque conductrice (4) et les conducteurs (5, 6) étant disposés essentiellement en parallèle aux surfaces de base de la plaque conductrice (4) et
- **en ce que** la plaque conductrice (4) est fixée en correspondance mécanique sur la plaque de couvercle (2) par des moyens de fixation (7) de telle sorte que le conducteur de raccordement (5) de la plaque de couvercle disposé sur le côté orienté vers la plaque de couvercle soit relié de manière électriquement conductrice à la plaque de couvercle.

2. Module semi-conducteur de puissance selon la revendication 1, **caractérisé en ce que** les moyens de fixation (7) sont disposés dans la zone occupée par les emplacements de liaison.

3. Module semi-conducteur de puissance selon l'une des revendications 1 ou 2, **caractérisé en ce que** la plaque de recouvrement (2) et/ou le conducteur de raccordement (5, 51) de la plaque de couvercle présentent une bordure (22, 53) d'optimisation du contact dans la zone occupée par l'emplacement de liaison.

4. Module semi-conducteur de puissance selon l'une des revendications 1 à 3, **caractérisé en ce que**
- la plaque de couvercle (2) et la plaque conductrice (4) présentent chacune au moins deux saillies (21),
- **en ce qu'**une saillie de la plaque de couvercle (21) et une saillie de la plaque conductrice (41) sont disposées l'une au-dessus de l'autre,
- **en ce que** les moyens de fixation (7) sont disposés dans la zone occupée par les saillies (21, 41),
- **en ce que** la plaque conductrice (4) présente au moins une autre saillie (42) entre les deux saillies (41) et
- **en ce que** les bornes de raccordement (52, 61) sont disposées sur cette autre saillie (42).
